# EUROPÄISCHE PATENTANMELDUNG

(11) **EP 4 119 848 A1**
(43) Veröffentlichungstag der Anmeldung: **18.01.2023**
(21) Anmeldenummer: 22178344.2
(22) Anmeldetag: 10.06.2022
(51) Int. Cl.: F24C 7/08, A47L 15/42, D06F 34/32, H03K 17/96

(54) **BEDIENEINRICHTUNG EINES HAUSHALTSGERÄTS UND HAUSHALTSGERÄT**

(30) Priorität: 16.07.2021 DE 102021118409
(71) Anmelder: Miele & Cie. KG, 33332 Gütersloh (DE)
(72) Erfinder: Banmann, Johann, 33334 Gütersloh (DE); Paul, Michael, 33378 Rheda-Wiedenbrück (DE); Schniedermann, Marc, 33758 Schloß Holte-Stukenbrock (DE); Kahlert, Wolfgang, 33334 Gütersloh (DE); Hunger, Helmut, 33335 Gütersloh (DE)

(57) **Zusammenfassung**

Die Erfindung betrifft ein Bedieneinrichtung (2) eines Haushaltsgeräts, umfassend eine die Bedieneinrichtung (2) nach außen abschließende Geräteblende (4), ein an einer Innenseite (6) der Geräteblende (4) angeordnetes Elektronikgehäuse (8) zur Aufnahme einer Leiterplatte (10) der Bedieneinrichtung (2) mit einer auf der Leiterplatte (10) angeordneten Elektronik (12) der Bedieneinrichtung (2), wobei die Elektronik (12) mittels mindestens einer Kontaktvorrichtung (14) der Bedieneinrichtung (2) mit der Geräteblende (4) derart verbunden ist, dass ein zu einem geräteblendenseitigen Ende der jeweiligen Kontaktvorrichtung (14) korrespondierender Flächenabschnitt (16) einer Außenseite (18) der Geräteblende (4) eine berührungssensitive Bedienfläche ausbildet, und wobei die Elektronik (12), die mindestens eine Kontaktvorrichtung (14) und die Geräteblende (4) derart aufeinander abgestimmt ausgebildet sind, dass die Bedieneinrichtung (2) als eine kapazitive Bedieneinrichtung wirkt, dadurch gekennzeichnet, dass die mindestens eine Kontaktvorrichtung (14) jeweils einerseits ein der Geräteblende (4) zugeordnetes und das geräteblendenseitige Ende aufweisendes elektrisch leitfähiges Kontaktelement (20) und andererseits eine von dem Kontaktelement (20) separate und der Leiterplatte (10) mit der Elektronik (12) zugeordnete elektrisch leitfähige Kontaktfeder (22) aufweist.

Ferner betriff die Erfindung ein Haushaltsgerät.

## Beschreibung

Die Erfindung betrifft eine Bedieneinrichtung eines Haushaltsgeräts der im Oberbegriff des Patentanspruchs 1 genannten Art und ein Haushaltsgerät.

Derartige Bedieneinrichtungen von Haushaltsgeräten und damit ausgestattete Haushaltsgeräte sind aus dem Stand der Technik bereits in einer Vielzahl von Ausführungsformen vorbekannt. Die bekannten Bedieneinrichtungen umfassen dabei eine die Bedieneinrichtung nach außen abschließende Geräteblende, ein an einer Innenseite der Geräteblende angeordnetes Elektronikgehäuse zur Aufnahme einer Leiterplatte der Bedieneinrichtung mit einer auf der Leiterplatte angeordneten Elektronik der Bedieneinrichtung, wobei die Elektronik mittels mindestens einer Kontaktvorrichtung der Bedieneinrichtung mit der Geräteblende derart verbunden ist, dass ein zu einem geräteblendenseitigen Ende der jeweiligen Kontaktvorrichtung korrespondierender Flächenabschnitt einer Außenseite der Geräteblende eine berührungssensitive Bedienfläche ausbildet, und wobei die Elektronik, die mindestens eine Kontaktvorrichtung und die Geräteblende derart aufeinander abgestimmt ausgebildet sind, dass die Bedieneinrichtung als eine kapazitive Bedieneinrichtung wirkt.

Der Erfindung stellt sich somit das Problem, eine Bedieneinrichtung eines Haushaltsgeräts und ein Haushaltsgerät zu verbessern.

Erfindungsgemäß wird dieses Problem durch eine Bedieneinrichtung eines Haushaltsgeräts mit den Merkmalen des Patentanspruchs 1 gelöst, die dadurch gekennzeichnet ist, dass die mindestens eine Kontaktvorrichtung jeweils einerseits ein der Geräteblende zugeordnetes und das geräteblendenseitige Ende aufweisendes elektrisch leitfähiges Kontaktelement und andererseits eine von dem Kontaktelement separate und der Leiterplatte mit der Elektronik zugeordnete elektrisch leitfähige Kontaktfeder aufweist. Ferner wird dieses Problem durch ein Haushaltsgerät mit den Merkmalen des Patentanspruchs 8 gelöst. Vorteilhafte Ausgestaltungen und Weiterbildungen der Erfindung ergeben sich aus den nachfolgenden Unteransprüchen.

Der mit der Erfindung erreichbare Vorteil besteht insbesondere darin, dass eine Bedieneinrichtung eines Haushaltsgeräts und ein Haushaltsgerät verbessert sind. Aufgrund der erfindungsgemäßen Ausbildung der Bedieneinrichtung eines Haushaltsgeräts und des Haushaltsgeräts ist eine kapazitive Touchbedienung bei Haushaltsgeräten auf konstruktiv und fertigungstechnisch einfache Art und Weise umsetzbar. Entsprechend können derartige kapazitive Touchbedienungen auch bei eher niedrigpreisigen Haushaltsgeräten verwendet werden. Darüber hinaus ermöglicht das Kontaktelement eine bessere Kraftverteilung einer mittels der dem jeweiligen Kontaktelement zugeordneten Kontaktfeder auf die Innenseite der Geräteblende einwirkenden Federkraft. Entsprechend kommt es auch bei Geräteblenden aus verformbaren Materialien, beispielsweise Kunststoff, nicht zu einer ungewünschten Deformation der Geräteblende aufgrund der vorgenannten Federkraft. Bei der vorgenannten ungewünschten Deformation der Geräteblende kann es sich beispielsweise um den sogenannten Kaltfluss handeln. Die mit der erfindungsgemäßen Bedieneinrichtung ausgestatteten Haushaltsgeräte können als sogenannte weiße Ware oder als sogenannte braune Ware ausgebildet sein. Rein exemplarisch seien hier genannt: Spülmaschinen, Backöfen und Waschmaschinen. Selbstverständlich ist es möglich, die Erfindung auch bei gewerblichen Geräten, also Geräten für den professionellen Einsatz, vorteilhaft einzusetzen.

Grundsätzlich ist die erfindungsgemäße Bedieneinrichtung nach Art, Funktionsweise, Material und Dimensionierung in weiten geeigneten Grenzen frei wählbar. Siehe hierzu beispielsweise die obigen Ausführungen.

Eine vorteilhafte Weiterbildung der erfindungsgemäßen Bedieneinrichtung sieht vor, dass das Kontaktelement an dem Elektronikgehäuse angeordnet ist, bevorzugt, dass das Kontaktelement das Elektronikgehäuse abdichtend an dem Elektronikgehäuse angeordnet ist, besonders bevorzugt, dass das Kontaktelement als ein integraler Bestandteil des Elektronikgehäuses ausgebildet ist. Hierdurch ist das Kontaktelement beispielsweise gemeinsam mit dem Elektronikgehäuse herstellbar. Ferner ist das Kontaktelement verliersicher an dem Elektronikgehäuse angeordnet und bei der Überführung der erfindungsgemäßen Bedieneinrichtung in deren Montagezustand, also bei der Montage der Bedieneinrichtung an einem Rest des Haushaltsgeräts, einerseits zu dem Elektronikgehäuse und andererseits zu dem vorgenannten Rest des Haushaltsgeräts ordnungsgemäß positioniert. Ferner ist dadurch die Anzahl der Bauteile reduziert. Besonders vorteilhaft ist die bevorzugte Ausführungsform dieser Weiterbildung, da hierdurch eine Abdichtung des Elektronikgehäuses im Bereich der mindestens einen Kontaktvorrichtung auf konstruktiv und fertigungstechnisch sehr einfache Art realisiert ist. Die besonders bevorzugte Ausführungsform dieser Weiterbildung stellt darüber hinaus eine zusätzliche Vereinfachung in der Konstruktion und der Fertigung der erfindungsgemäßen Bedieneinrichtung dar.

Eine zu der vorgenannten Weiterbildung alternative vorteilhafte Weiterbildung der erfindungsgemäßen Bedieneinrichtung sieht vor, dass das Kontaktelement an der Innenseite der Geräteblende angeordnet ist. Auf diese Weise ist die vorgenannte konstruktiv und fertigungstechnisch einfache Umsetzung der erfindungsgemäßen Bedieneinrichtung auf anderem Wege erzielbar.

Eine weitere vorteilhafte Weiterbildung der erfindungsgemäßen Bedieneinrichtung sieht vor, dass das Kontaktelement als ein elastisches Kontaktelement ausgebildet ist. Hierdurch ist bei dem jeweiligen Kontaktelement mittels des Kontaktelements zum einen ein zusätzlicher Toleranzausgleich ermöglicht. Zum anderen ist dadurch eine innige Anlage des Kontaktelements einerseits an der diesem zugeordneten Kontaktfeder und andererseits an der Innenseite der Geräteblende ermöglicht.

Eine besonders vorteilhafte Weiterbildung der erfindungsgemäßen Bedieneinrichtung sieht vor, dass das Kontaktelement als ein Kunststoffteil ausgebildet ist, bevorzugt, dass das Kontaktelement an das Elektronikgehäuse oder die Geräteblende angespritzt ist, besonders bevorzugt, dass das Elektronikgehäuse oder die Geräteblende ebenfalls als ein Kunststoffteil ausgebildet ist. Auf diese Weise ist die erfindungsgemäße Bedieneinrichtung konstruktiv und fertigungstechnisch weiter vereinfacht. Dies gilt besonders für die bevorzugte und insbesondere für die besonders bevorzugte Ausführungsform dieser Weiterbildung.

Eine andere vorteilhafte Weiterbildung der erfindungsgemäßen Bedieneinrichtung sieht vor, dass die Kontaktfeder als eine Metallfeder ausgebildet ist, bevorzugt, dass die Kontaktfeder mit einer die Kontaktfeder mit der Elektronik elektrisch verbindenden Kontaktfläche der Leiterplatte verlötet ist. Hierdurch ist die Metallfeder auf konstruktiv und fertigungstechnisch einfache und sehr robuste Art und Weise realisiert.

Eine weitere vorteilhafte Weiterbildung der erfindungsgemäßen Bedieneinrichtung sieht vor, dass in einem Montagezustand der Bedieneinrichtung mittels der Leiterplatte die Kontaktfeder gegen das Kontaktelement vorgespannt ist oder die Kontaktfeder gegen das Kontaktelement und das Kontaktelement gegen die Geräteblende vorgespannt sind. Auf diese Weise ist eine innige kraftübertragende Verbindung zwischen der Leiterplatte und der Kontaktvorrichtung einerseits und zwischen der Kontaktvorrichtung und der Geräteblende andererseits verwirklicht. Entsprechend ist zwischen der Geräteblende und der Elektronik, trotz Bauteiltoleranzen und auch über eine lange Betriebszeit, eine sichere stromleitende Verbindung sichergestellt.

Ein Ausführungsbeispiel der Erfindung ist in den Zeichnungen rein schematisch dargestellt und wird nachfolgend näher beschrieben. Es zeigt
- Figur 1: ein Ausführungsbeispiel der erfindungsgemäßen Bedieneinrichtung eines erfindungsgemäßen Haushaltsgeräts in einer teilweisen, perspektivischen Explosionsdarstell ung,
- Figur 2: das Ausführungsbeispiel in einer Frontalansicht,
- Figur 3a: das Ausführungsbeispiel in einer ersten seitlichen Schnittdarstellung entlang der Schnittlinie A-A in der Fig. 2, bei der Überführung in den Montagezustand der Bedieneinrichtung,
- Figur 3b: das Ausführungsbeispiel in einer zweiten seitlichen Schnittdarstellung entlang der Schnittlinie A-A in der Fig. 2, mit der Bedieneinrichtung in deren Montagezustand, und
- Figur 4: ein weiteres Ausführungsbeispiel.

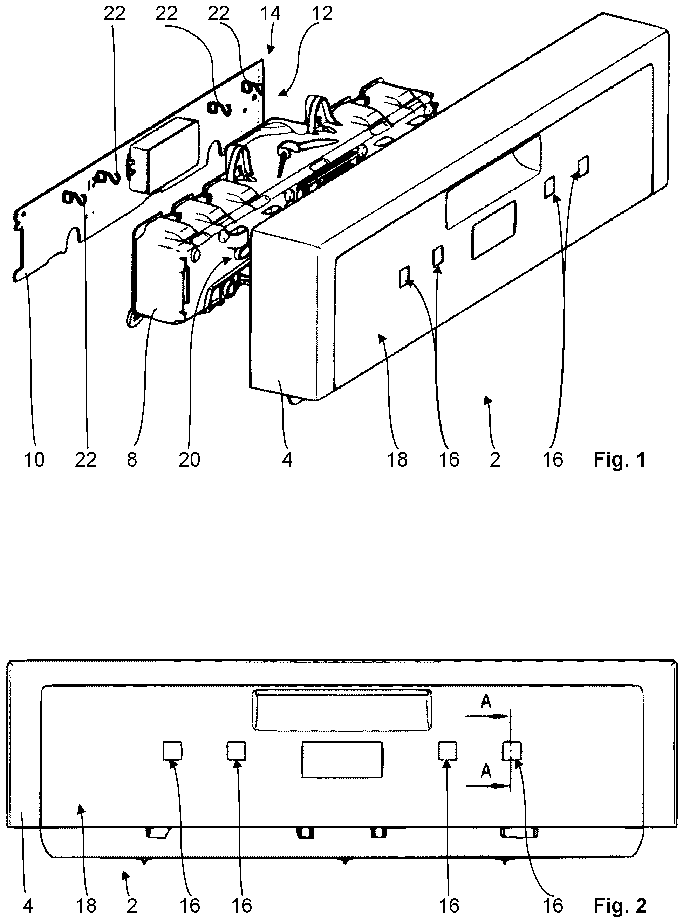

In den Fig. 1 bis 4 ist ein Ausführungsbeispiel der erfindungsgemäßen Bedieneinrichtung eines erfindungsgemäßen Haushaltsgeräts rein exemplarisch dargestellt.

Die Bedieneinrichtung 2 ist zur Montage an einem Rest des ansonsten nicht dargestellten Haushaltsgeräts ausgebildet und umfasst eine die Bedieneinrichtung 2 nach außen abschließende Geräteblende 4, ein an einer Innenseite 6 der Geräteblende 4 angeordnetes Elektronikgehäuse 8 zur Aufnahme einer Leiterplatte 10 der Bedieneinrichtung 2 mit einer auf der Leiterplatte 10 angeordneten Elektronik 12 der Bedieneinrichtung 2, wobei die Elektronik 12 mittels mindestens einer Kontaktvorrichtung 14 der Bedieneinrichtung 2 mit der Geräteblende 4 derart verbunden ist, dass ein zu einem geräteblendenseitigen Ende der jeweiligen Kontaktvorrichtung 14 korrespondierender Flächenabschnitt 16 einer Außenseite 18 der Geräteblende 4 eine berührungssensitive Bedienfläche ausbildet, und wobei die Elektronik 12, die mindestens eine Kontaktvorrichtung 14 und die Geräteblende 4 derart aufeinander abgestimmt ausgebildet sind, dass die Bedieneinrichtung 2 als eine kapazitive Bedieneinrichtung wirkt. Bei dem vorliegenden Ausführungsbeispiel weist die Bedieneinrichtung 2 insgesamt vier Kontaktvorrichtungen 14 auf, die alle zueinander identisch ausgebildet sind. Entsprechend wird im Nachfolgenden lediglich eine der insgesamt vier Kontaktvorrichtungen 14 näher erläutert. Die diesbezüglichen Ausführungen gelten jedoch für alle der insgesamt vier Kontaktvorrichtungen 14. Bei dem Haushaltsgerät handelt es sich um eine Spülmaschine.

Die jeweilige Kontaktvorrichtung 14 weist einerseits ein der Geräteblende 4 zugeordnetes und das geräteblendenseitige Ende aufweisendes elektrisch leitfähiges Kontaktelement 20 und andererseits eine von dem Kontaktelement 20 separate und der Leiterplatte 10 mit der Elektronik 12 zugeordnete elektrisch leitfähige Kontaktfeder 22 auf.

Das Kontaktelement 20 ist bei dem vorliegenden Ausführungsbeispiel an dem Elektronikgehäuse 8 angeordnet, nämlich derart, dass das Kontaktelement 20 das Elektronikgehäuse 8 abdichtend an dem Elektronikgehäuse 8 angeordnet ist, wobei das Kontaktelement 20 hier als ein integraler Bestandteil des Elektronikgehäuses 8 ausgebildet ist. Hierdurch ist das Elektronikgehäuse 8 in dem Bereich der jeweiligen Kontaktvorrichtung 14 auf konstruktiv und fertigungstechnisch einfache Art und Weise, beispielsweise gegen Flüssigkeit, abgedichtet. Alternativ hierzu kann es jedoch in anderen Ausführungsformen der erfindungsgemäßen Bedieneinrichtung vorgesehen sein, dass das Kontaktelement an der Innenseite der Geräteblende angeordnet ist.

Ferner ist das Kontaktelement 20 bei dem vorliegenden Ausführungsbeispiel als ein elastisches Kontaktelement aus Kunststoff ausgebildet, wobei das Kontaktelement 20 hier an das Elektronikgehäuse 8 angespritzt ist, und wobei das Elektronikgehäuse 8 ebenfalls als ein Kunststoffteil ausgebildet ist. Auch die Geräteblende 4 ist als ein Kunststoffteil ausgebildet.

Die Kontaktfeder 22 ist als eine Metallfeder ausgebildet, wobei die Kontaktfeder 22 mit einer die Kontaktfeder 22 mit der Elektronik 12 elektrisch verbindenden Kontaktfläche 24 der Leiterplatte 10 verlötet ist.

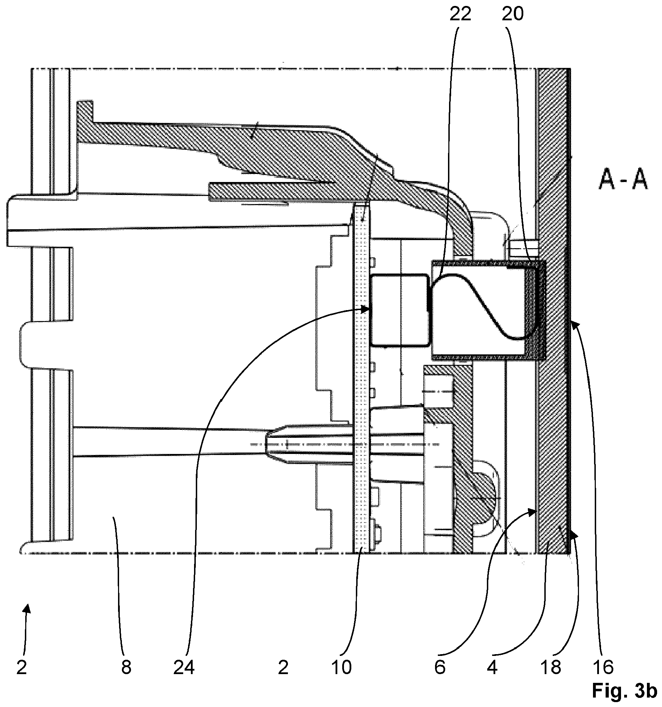

Um eine in jedem Betriebszustand und über eine lange Betriebszeit des Haushaltsgeräts sichere mechanische und damit stromleitende Anlage der Kontaktvorrichtung 14 einerseits an der Kontaktfläche 24 der Leiterplatte 10 und andererseits an der Innenseite 6 der Geräteblende 4 zu gewährleisten, sind die Kontaktfeder 22 gegen das Kontaktelement 20 und das Kontaktelement 20 gegen die Geräteblende 4 mittels der Leiterplatte 10 in einem in der Fig. 3b dargestellten Montagezustand der Bedieneinrichtung 2 vorgespannt.

Nachfolgend wird die Funktionsweise der erfindungsgemäßen Bedieneinrichtung und damit des erfindungsgemäßen Haushaltsgeräts gemäß dem vorliegenden Ausführungsbeispiel anhand der Fig. 1 bis 3b näher erläutert.

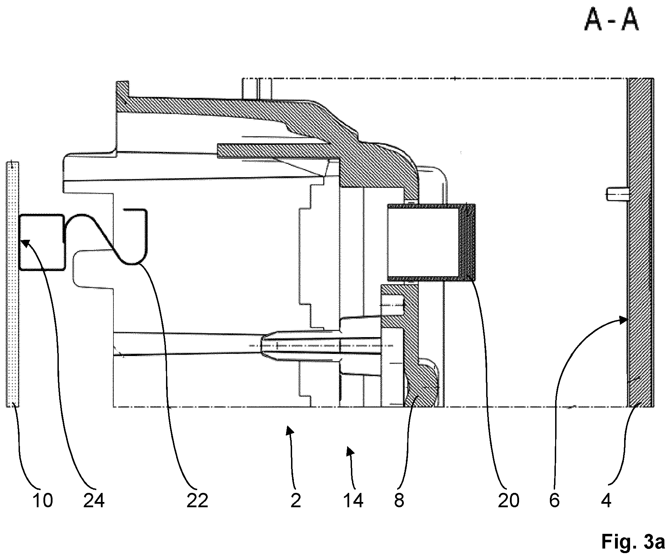

Zunächst befindet sich die Bedieneinrichtung 2 in einem aus den Fig. 1 und 3a ersichtlichen Demontagezustand, in dem die Bedieneinrichtung 2 selbst noch nicht montiert worden ist. Auch ist die Bedieneinrichtung 2 noch nicht an dem Rest des Haushaltsgeräts montiert.

Zwecks Überführung der Bedieneinrichtung 2 in deren aus der Fig. 3b ersichtlichen Montagezustand wird zunächst die Leiterplatte 10 mit der darauf angeordneten Elektronik 12 und den darauf angeordneten Kontaktfedern 22 der Kontaktvorrichtung 14 in der Bildebene der Fig. 3a von links nach rechts in das Elektronikgehäuse 8 eingeschoben und auf dem Fachmann an sich bekannte Weise mit dem Elektronikgehäuse 8 mechanisch verbunden. In diesem Zwischenzustand, in dem die Leiterplatte 10 mit der Elektronik 12 und den Kontaktfedern 22 in dem Elektronikgehäuse 8 aufgenommen ist, liegen die Kontaktfedern 22 an dem jeweils korrespondierenden Kontaktelement 20 derart innig an, dass eine stromleitende Verbindung von dem jeweiligen Kontaktelement 20, über die dazu korrespondierende Kontaktfeder 22 und die Kontaktfläche 24, auf der diese Kontaktfeder 22 aufgelötet ist, zu der Elektronik 12 in allen Betriebszuständen des Haushaltsgeräts und über die gesamte Betriebszeit des Haushaltsgeräts, also über dessen voraussichtliche Lebensdauer, gewährleistet ist. Hierfür liegt die jeweilige aus dem dieser zugeordneten Kontaktelement 20 und der dieser zugeordneten Kontaktfeder 22 gebildete Kontaktvorrichtung 14 in dem Montagezustand der Bedieneinrichtung 2 mit Vorspannung einerseits an der Leiterplatte 10 und andererseits an der Innenseite 6 der Geräteblende 4 an.

Zur Herstellung des vorgenannten und in der Fig. 3b gezeigten Montagezustands der Bedieneinrichtung 2 wird das Elektronikgehäuse 8 mit der Elektronik 12 und den Kontaktfedern 22 in der Bildebene der Fig. 3b von links nach rechts an die Innenseite 6 der Geräteblende 4 heranbewegt, bis das Elektronikgehäuse 8, wie aus der Fig. 3b ersichtlich, mit den Kontaktelementen 22 der Kontaktvorrichtung 14 unter Vorspannung an der Innenseite 6 der Geräteblende 4 anliegt. Siehe hierzu auch die Fig. 3a und 3b in einer Zusammenschau.

Zum Schluss wird die Bedieneinrichtung 2 auf dem Fachmann an sich bekannte Weise mit dem Rest des Haushaltsgeräts verbunden.

Sobald nun ein nicht dargestellter Benutzer des als Spülmaschine ausgebildeten Haushaltsgeräts einen der vier den vier Kontaktvorrichtungen 14 zugeordneten Flächenabschnitten 16 an der Außenseite 18 der Geräteblende 4 mit einem Finger berührt, beispielsweise den in der Fig. 3b dargestellten Flächenabschnitt 16, erfolgt durch die Geräteblende 4 hindurch eine kapazitive Veränderung an der durch das Kontaktelement 20 und die Kontaktfeder 22 ausgebildeten Kontaktvorrichtung 14 und damit an der dieser Kontaktvorrichtung 14 zugeordneten Kontaktfläche 24 der Leiterplatte 10, die mit der Elektronik 12 stromleitend verbunden ist.

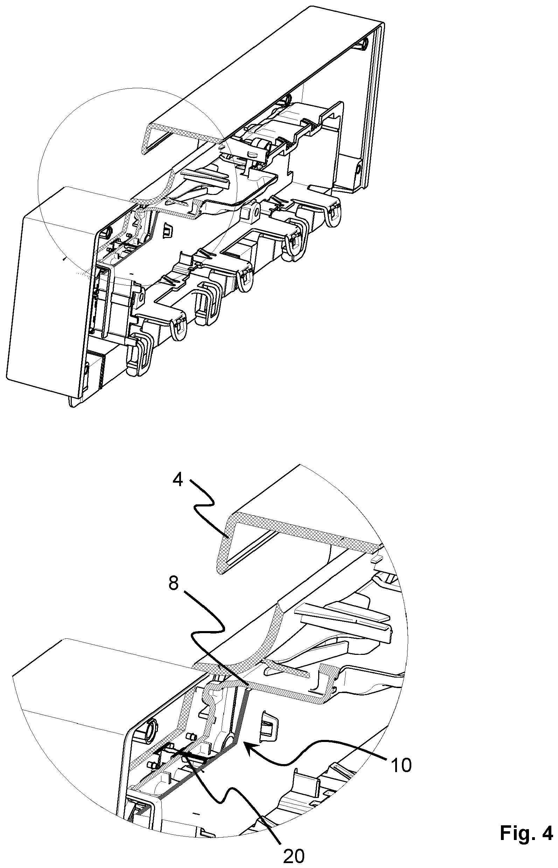

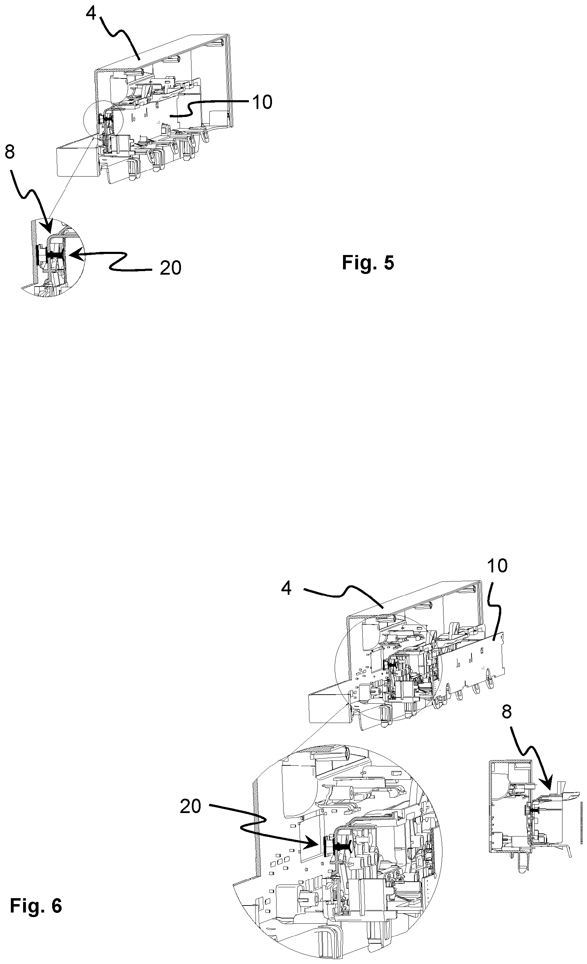

Fig. 4, 5 und 6 zeigen eine alternative Ausführungsform hinsichtlich der der Touch-Verbindung. Bei der Variante wird kein aufgelötetes Element auf der Leiterkarte 10 benötigt, sondern diese Funktion wird durch das leitfähige Kontaktelement 20 aus Kunststoff erfüllt. Somit ist dieses leitfähige, in das Gehäuse 8 eingespritzte Element das Bauteil, welches die Weiterleitung des Touch-Impulses übernimmt.

Aufgrund der erfindungsgemäßen Ausbildung der Bedieneinrichtung eines Haushaltsgeräts und des damit ausgestatteten Haushaltsgeräts ist eine kapazitive Touchbedienung bei Haushaltsgeräten auf konstruktiv und fertigungstechnisch einfache Art und Weise umsetzbar. Entsprechend können derartige kapazitive Touchbedienungen auch bei eher niedrigpreisigen Haushaltsgeräten verwendet werden. Darüber hinaus ermöglicht das Kontaktelement 20 eine bessere Kraftverteilung einer mittels der dem jeweiligen Kontaktelement 20 zugeordneten Kontaktfeder 22 auf die Innenseite 6 der Geräteblende 4 einwirkenden Federkraft.

Entsprechend kommt es auch bei Geräteblenden 4 aus verformbaren Materialien, beispielsweise Kunststoff, nicht zu einer ungewünschten Deformation der Geräteblende 4 aufgrund der vorgenannten Federkraft.

Die Erfindung ist nicht auf das vorliegende Ausführungsbeispiel beschränkt.

Beispielsweise können die mit der erfindungsgemäßen Bedieneinrichtung ausgestatteten Haushaltsgeräte als sogenannte weiße Ware oder als sogenannte braune Ware ausgebildet sein. Rein exemplarisch seien hier genannt: Backöfen und Waschmaschinen. Selbstverständlich ist es möglich, die Erfindung auch bei gewerblichen Geräten, also Geräten für den professionellen Einsatz, vorteilhaft einzusetzen.

Insbesondere ist die Erfindung nicht auf die konstruktiven und fertigungstechnischen Details des erläuterten Ausführungsbeispiels begrenzt.

## Patentansprüche

1. Bedieneinrichtung (2) eines Haushaltsgeräts zur Montage an einem Rest des Haushaltsgeräts, umfassend eine die Bedieneinrichtung (2) nach außen abschließende Geräteblende (4), ein an einer Innenseite (6) der Geräteblende (4) angeordnetes Elektronikgehäuse (8) zur Aufnahme einer Leiterplatte (10) der Bedieneinrichtung (2) mit einer auf der Leiterplatte (10) angeordneten Elektronik (12) der Bedieneinrichtung (2), wobei die Elektronik (12) mittels mindestens einer Kontaktvorrichtung (14) der Bedieneinrichtung (2) mit der Geräteblende (4) derart verbunden ist, dass ein zu einem geräteblendenseitigen Ende der jeweiligen Kontaktvorrichtung (14) korrespondierender Flächenabschnitt (16) einer Außenseite (18) der Geräteblende (4) eine berührungssensitive Bedienfläche ausbildet, und wobei die Elektronik (12), die mindestens eine Kontaktvorrichtung (14) und die Geräteblende (4) derart aufeinander abgestimmt ausgebildet sind, dass die Bedieneinrichtung (2) als eine kapazitive Bedieneinrichtung wirkt, **dadurch gekennzeichnet, dass** die mindestens eine Kontaktvorrichtung (14) jeweils einerseits ein der Geräteblende (4) zugeordnetes und das geräteblendenseitige Ende aufweisendes elektrisch leitfähiges Kontaktelement (20) und andererseits eine von dem Kontaktelement (20) separate und der Leiterplatte (10) mit der Elektronik (12) zugeordnete elektrisch leitfähige Kontaktfeder (22) aufweist.

2. Bedieneinrichtung (2) nach Anspruch 1, **dadurch gekennzeichnet, dass** das Kontaktelement (20) an dem Elektronikgehäuse (8) angeordnet ist, bevorzugt, dass das Kontaktelement (20) das Elektronikgehäuse (8) abdichtend an dem Elektronikgehäuse (8) angeordnet ist, besonders bevorzugt, dass das Kontaktelement (20) als ein integraler Bestandteil des Elektronikgehäuses (8) ausgebildet ist.

3. Bedieneinrichtung (2) nach Anspruch 1, **dadurch gekennzeichnet, dass** das Kontaktelement (20) an der Innenseite (6) der Geräteblende (4) angeordnet ist.

4. Bedieneinrichtung (2) nach einem der Ansprüche 1 bis 3, **dadurch gekennzeichnet, dass** das Kontaktelement (20) als ein elastisches Kontaktelement ausgebildet ist.

5. Bedieneinrichtung (2) nach einem der Ansprüche 1 bis 4, **dadurch gekennzeichnet, dass** das Kontaktelement (20) als ein Kunststoffteil ausgebildet ist, bevorzugt, dass das Kontaktelement (20) an das Elektronikgehäuse (8) oder die Geräteblende angespritzt ist, besonders bevorzugt, dass das Elektronikgehäuse (8) oder die Geräteblende (4) ebenfalls als ein Kunststoffteil ausgebildet ist.

6. Bedieneinrichtung (2) nach einem der Ansprüche 1 bis 5, **dadurch gekennzeichnet, dass** die Kontaktfeder (22) als eine Metallfeder ausgebildet ist, bevorzugt, dass die Kontaktfeder (22) mit einer die Kontaktfeder (22) mit der Elektronik (12) elektrisch verbindenden Kontaktfläche (24) der Leiterplatte (10) verlötet ist.

7. Bedieneinrichtung (2) nach einem der Ansprüche 1 bis 6, **dadurch gekennzeichnet, dass** in einem Montagezustand der Bedieneinrichtung (2) mittels der Leiterplatte (10) die Kontaktfeder gegen das Kontaktelement vorgespannt ist oder die Kontaktfeder (22) gegen das Kontaktelement (20) und das Kontaktelement (20) gegen die Geräteblende (4) vorgespannt sind.

8. Haushaltsgerät mit einer Bedieneinrichtung (2), **dadurch gekennzeichnet, dass** die Bedieneinrichtung (2) nach einem der Ansprüche 1 bis 7 ausgebildet ist.
